(19) Europäisches Patentamt
European Patent Office
Office européen des brevets

(11) Veröffentlichungsnummer: **0 003 040**
**B1**

(12) # EUROPÄISCHE PATENTSCHRIFT

(45) Veröffentlichungstag der Patentschrift: **07.09.83**

(51) Int. Cl.³: **G 03 C 1/68,** C 08 G 59/16

(21) Anmeldenummer: **78101833.8**

(22) Anmeldetag: **23.12.78**

(54) **Strahlungsempfindliche Überzugsmasse und Verfahren zur Herstellung eines negativen Photoresistbildes.**

(30) Priorität: **09.01.78 US 867996**

(43) Veröffentlichungstag der Anmeldung: **25.07.79 Patentblatt 79/15**

(45) Bekanntmachung des Hinweises auf die Patenterteilung: **07.09.83 Patentblatt 83/36**

(84) Benannte Vertragsstaaten: **DE FR GB**

(56) Entgegenhaltungen:
**DE-A-2 207 853**
**DE-A-2 320 849**
**FR-A-2 120 833**
**FR-A-2 144 802**
**FR-A-2 255 629**
**FR-A-2 274 652**
**FR-A-2 339 657**
**FR-A-2 361 681**
**US-A-3 301 743**
**US-A-3 637 618**
**US-A-3 674 524**
**US-A-3 980 483**

(73) Patentinhaber: **International Business Machines Corporation, Old Orchard Road, Armonk, N.Y. 10504 (US)**

(72) Erfinder: **Shipley, John Frank, P.O. Box 556, Endicott NY 13760 (US)**

(74) Vertreter: **Kreidler, Eva-Maria, Dr. rer. nat., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



BUNDESDRUCKEREI BERLIN

# Strahlungsempfindliche Überzugsmasse und Verfahren zur Herstellung eines negativen Photoresistbildes

Die Erfindung betrifft eine strahlungsempfindliche Überzugsmasse und deren Verwendung als negativer Photoresist. Die Überzugsmasse besteht aus Vorreaktionsprodukten zweier verschiedener Epoxidpolymerer mit monoäthylenisch ungesättigten Carbonsäuren, einer polyäthylenisch ungesättigten Verbindung, einem Photoinitiator und gegebenenfalls einem nicht reaktiven Verdünnungsmittel.

Epoxidharzmassen und deren Verwendung als lichtempfindliche Photoresistmaterialien sind bekannt. So wurde beispielsweise die Verwendung bestimmter Reaktionsprodukte einer monoäthylenisch ungesättigten Säure und bestimmter Epoxide für die Herstellung von Mustern, wie gedruckte elektronische Schaltkreise, in der US-Patentschrift 3 661 576 und der deutschen Patentschrift 2 459 179 beschrieben. Bei der Herstellung der in der deutschen Patentschrift 2 459 179 beschriebenen Überzugszusammensetzungen findet aber gleichzeitig mit der, oder anschließend an die Umsetzung des Epoxids mit der $\alpha,\beta$-äthylenisch ungesättigten Carbonsäure eine Additionsreaktion zwischen dem Epoxid und einem primären aromatischen Amin statt. Weiterhin sind lichtempfindliche Zusammensetzungen auf der Basis von Epoxidharzen, bei denen keine Vorreaktion mit einer monoäthylenisch ungesättigten Säure stattgefunden hat, die aber bestimmte spezifische Typen von Sensibilisatoren enthalten, zur Herstellung selektiver Überzüge oder Überzugsmuster beschrieben worden. Als Beispiel hierfür sei die US-Patentschrift 3 930 856 genannt.

Es wurden auch verschiedene Überzugsmassen mit einem Gehalt an monoäthylenisch ungesättigter Säure-Epoxid-Addukten zur Herstellung von Überzügen beschrieben, bei denen es auf die Auflösung, die für die Verwendung als lichtempfindlicher Photoresist bei der Herstellung gedruckter Schaltkreise erforderlich ist, nicht ankommt. Beispiele dieser Art sind in den US-Patentschriften 3 912 670, 3 772 062, 3 450 613 und 4 003 877 beschrieben.

In der deutschen Offenlegungsschrift 2 207 853 ist eine photoempfindliche dielektrische Zusammensetzung beschrieben, die ein Epoxidharz vom Bisphenol-A- oder Novolak-Typ, ein mehrfunktionelles Vinylmonomersystem, einen Photoinitiator und ein nichtreaktives Verdünnungsmittel enthält. Bei dieser Zusammensetzung werden jedoch keine Epoxidharze verwendet, die mit einer monoäthylenisch ungesättigten Carbonsäure reagiert haben. Die übrigen Bestandteile werden in anderen Mengen eingesetzt, und die erhaltene Überzugsmasse weist nicht die hohe Auflösung und Bildschärfe und die ausgezeichneten filmbildenden Eigenschaften der Überzugsmasse gemäß der Erfindung auf.

Die Bereitstellung von Überzugsmassen, welche brauchbare Eigenschaften zur Bilderzeugung (Auflösung und Bildschärfe) aufweisen, damit sie zur Bilderzeugung oder zur Herstellung einer Maske insbesondere für integrierte Schaltkreise geeignet sind und die gleichzeitig die notwendigen physikalischen Eigenschaften für einen bleibenden Schutzüberzug aufweisen, ist sehr schwierig. Im einzelnen müssen Zusammensetzungen, die zu einem Schutzüberzug in Form eines Musters für eine Schaltkreisplatte geeignet sind, eine Vielzahl verschiedener Eigenschaften aufweisen. In vielen Fällen ist in Abhängigkeit von der spezifischen Verwendung und/oder den Bedingungen der Umgebung und in Abhängigkeit von den gesetzten Prioritäten ein Kompromiß zwischen diesen Eigenschaften erforderlich. In einem speziellen Fall wird eine Eigenschaft bis zu einem zufriedenstellenden Grad bei gleichzeitiger Abnahme einer anderen Eigenschaft erreicht. Bei vielen Überzügen werden beispielsweise die filmbildenden Eigenschaften geopfert, um zufriedenstellende Auflösung und Bildschärfe zu erhalten, und in gleicher Weise wurde, wenn es möglich war, die Bildschärfe geopfert, um die gewünschten filmbildenden Eigenschaften zu erhalten.

Bei der Herstellung integrierter Schaltkreisplatten ist es erwünscht, daß in dem zur Anwendung kommenden Polymermaterial mittels eines photolythischen Prozesses ein Muster hergestellt werden kann, wie das für Photoresistmaterialien üblich ist, und das, anders als bei einem Photoresist, zusätzlich eine oder mehrere Funktionen während oder nach der Herstellung der gedruckten Schaltkreisplatte ausführen kann. Auf Grund der einmaligen Kombination guter Eigenschaften, die durch die Zusammensetzungen der vorliegenden Erfindung erhalten werden, ist es möglich, die Überzugsmasse zur Herstellung einer permanent verbleibenden Ätzmaske, einer Lötmaske, einer Metallabscheidemaske, eines dielektrischen Films oder eines Schutzüberzugs zu verwenden.

Durch die spezielle Kombination der Überzugsmassen der vorliegenden Erfindung werden lichthärtbare Überzüge erhalten, die nicht nur eine gute Auflösung (d. h. scharf definierte Bilder) ergeben, sondern auch ausgezeichnete filmbildende Eigenschaften wie gute Flexibilität und Zähigkeit aufweisen. Darüber hinaus wurde beobachtet, daß der Schichtdickenverlust der gehärteten Teile während der Entwicklung viel geringer ist, als wenn andere lichthärtbare Epoxidharzüberzüge, beispielsweise die, die in der deutschen Patentschrift 2 459 179 beschrieben sind, verwendet werden. Ein weiterer Vorteil ist, daß die Zusammensetzungen gemäß der Erfindung nicht klebrig sind. Sie können daher in einem Verfahren mit den nachfolgenden Schritten angewendet werden:

1. Auftragen des Materials auf einen Filmträger, beispielsweise auf einen billigen Polyäthylenträger;
2. Laminieren des Films mit dem Träger auf eine Schaltplatte;

3. Entfernen des Trägers und
4. Belichten und Entwickeln der Überzugsmasse.

Andererseits sind die im Handel erhältlichen Photoresistzusammensetzungen, die unter Verwendung eines Trägers in einem Verfahren, das in dem US-Patent 3 469 982 beschrieben ist, angewendet werden, im allgemeinen nicht für den zuvor angegebenen Prozeß geeignet. Beispielsweise wird bei den im Handel erhältlichen Photoresistmaterialien ein teurer transparenter Träger aus Polyäthylenterephthalat verwendet und der Photoresist wird durch den Träger belichtet. Die allgemein im Handel erhältlichen Photoresistmaterialien sind etwas klebrig, und deshalb kann der Träger nicht vor der Belichtung von ihnen entfernt werden, weil Teile des Photoresists an der Belichtungsmaske haften bleiben. Wenn der Träger entfernt würde, würden Teile des Photoresists zusammen mit dem Träger entfernt werden.

Ein Vorteil, der durch das Entfernen des Trägers vor der Belichtungsstufe erhalten wird, ist, daß ein gewisser Bildabbau, der bei Belichten durch den Träger stattfindet, wie in den Beispielen der US-Patentschrift 3 469 982 beschrieben ist, vermieden wird.

Es wird angenommen, daß die allgemein im Handel erhältlichen Photoresistmaterialien eine relativ große Menge eines flüssigen, vernetzend wirkenden Mittels enthalten, während die Zusammensetzungen der vorliegenden Erfindung mit nur relativ geringen Mengen eines mehrfach äthylenisch ungesättigten, vernetzend wirkenden Mittels hergestellt werden können, weil der größte Teil der Vernetzung durch die Kettenmoleküle selbst stattfinden kann.

Aufgabe der Erfindung ist die Bereitstellung einer Überzugsmasse mit Eigenschaften, die die gleichzeitige Verwendung als Photoresist und als Schutzüberzug auf integrierten Schaltkreisplatten gestatten.

Diese Aufgabe wird gelöst durch die Überzugsmasse, wie sie in den Ansprüchen 1 bis 9 gekennzeichnet ist. Die Erfindung umfaßt auch ein Verfahren zur Herstellung eines negativen Photoresistbildes auf einer Schaltkreisplatte. Vorteilhafte Ausführungsformen der Erfindung sind in den abhängigen Ansprüchen niedergelegt. Mit der Erfindung werden die zuvor angegebenen Vorteile erhalten.

Nachfolgend wird die Erfindung anhand der speziellen Beschreibung und der Ausführungsbeispiele näher erläutert.

Gemäß der vorliegenden Erfindung wird eine Kombination von Reaktionsprodukten $\alpha,\beta$-äthylenisch ungesättigter Carbonsäuren mit zwei verschiedenen Epoxidpolymeren verwendet. Die $\alpha,\beta$-äthylenisch ungesättigten Carbonsäuren sind gut bekannt und leicht im Handel erhältlich. Beispiele solcher Säuren sind Acrylsäure, Methacrylsäure und Crotonsäure. Die erfindungsgemäß bevorzugte äthylenisch ungesättigte Carbonsäure ist Acrylsäure.

Eines des Epoxidpolymeren, das mit der äthylenisch ungesättigten Carbonsäure umgesetzt wird, ist ein 2.2-Bis(4-hydroxyphenyl)propan (Bisphenol A)-diglycidyläther, beispielsweise ein Polymer aus 2.2-Bis(4-hydroxyphenyl)propan und Epichlorhydrin.

Das Epoxid hat die nachfolgend angegebene allgemeine Formel (I):

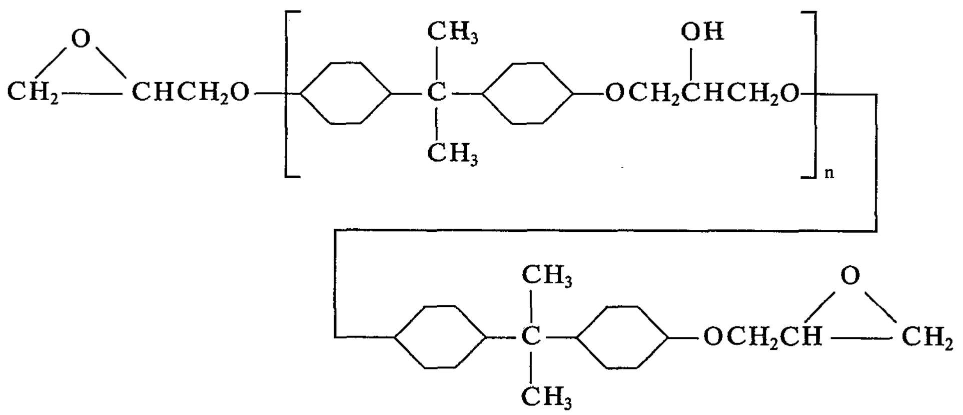

(I)

Es kann flüssig oder fest sein, je nach Molekulargewicht, welches im allgemeinen in einem Bereich von $3 \times 10^2$ bis etwa $10 \times 10^4$ liegt. n in der oben angegebenen Formel variiert von 0,2 bis 100, vorzugsweise von 0,2 bis 25, beziehungsweise bis etwa 10. Mischungen von Epoxidpolymeren der zuvor angegebenen Formel mit verschiedenen Molekulargewichten können, wenn es gewünscht wird, verwendet werden. So kann es beispielsweise erwünscht sein, geringe Mengen eines Epoxidpolymeren mit relativ hohem Molekulargewicht (d. h. n von 10 bis 100) in Kombination mit einem Epoxidpolymeren mit niedrigem Molekulargewicht (n von 0,2 bis 10) zu verwenden, um die filmbildenden Eigenschaften zu erhöhen oder um den Film auf den Träger auflaminieren zu können, ohne daß dabei die wirklich ausgezeichnete Lichtempfindlichkeit, die mit den niedrigmolekularen Anteilen der Epoxidpolymeren erhalten wird, geopfert werden muß.

Die Hauptanforderungen an dieses Epoxidpolymer sind, daß sein Reaktionsprodukt mit der Säure filmbildend ist. Die relativen Mengen monoäthylenisch ungesättigter Säure im Verhältnis zu dem Epoxid der Formel (I), die in der vorliegenden Erfindung verwendet werden, sind ausreichend zur stöchiometrischen Umsetzung mit 25 bis 100%, vorzugsweise 25 bis 75% der Epoxidfunktionalität dieses Epoxidharzes. Am meisten bevorzugt ist eine Umsetzung von etwa 75%. Je höher der Anteil der Säure ist, desto besser ist die Zähigkeit des Films und desto schärfer ist das Bild.

Das andere Epoxidpolymere, das angewendet wird, ist ein epoxidierter Novolak der allgemeinen Formel (II):

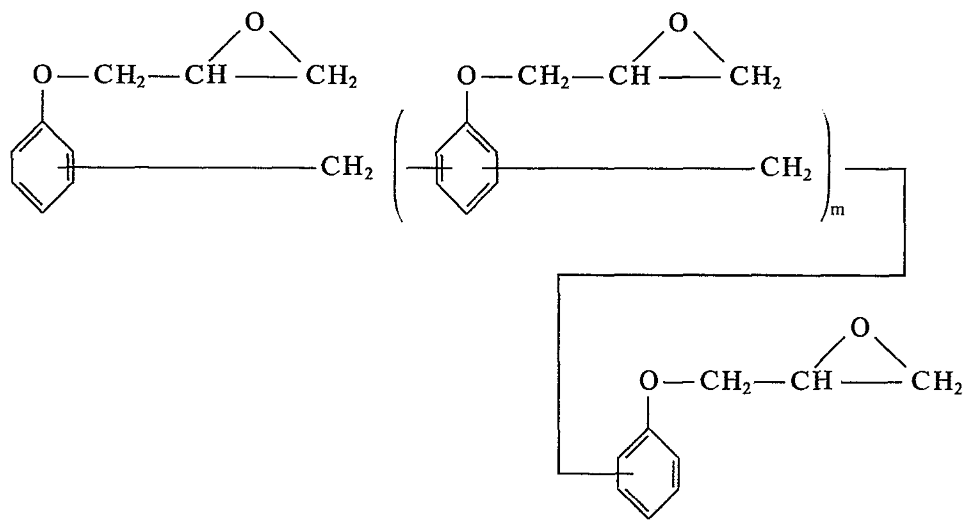

(II)

wobei m 1,5 bis 3,5 ist.

Dieses Epoxidpolymere kann in Abhängigkeit von seinem Molekulargewicht flüssig, halbfest oder fest sein. Epoxidpolymere mit m von 1,5 bis 3,5 sind im Handel erhältlich. Es können auch, wenn es gewünscht wird, Epoxidpolymere der zuvor angegebenen Formel mit verschiedenen Molekulargewichten verwendet werden.

Die relative Menge der monoäthylenisch ungesättigten Säure im Verhältnis zu den epoxidierten Novolakpolymeren wird so gewählt, daß 25 bis 100%, vorzugsweise 25 bis 75% der Epoxidfunktionalität des Novolakharzes stöchiometrisch mit der Säure reagieren. Am meisten bevorzugt ist eine Umsetzung von etwa 75%. Je höher der relative Anteil an Säure ist, desto besser sind die Eigenschaften zur Filmbildung und Bilderzeugung.

Die Reaktionsprodukte sind wahrscheinlich Additionsprodukte, die wie nachfolgend angegeben gebildet werden:

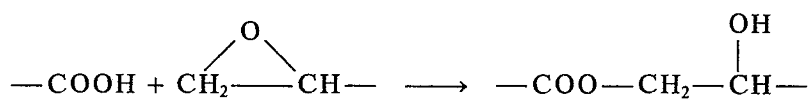

Für die relativen Mengen der beiden Epoxidharzbestandteile ist ein Verhältnis von 1 : 4 bis 4 : 1, vorzugsweise von etwa 1 : 3 bis etwa 3 : 1 und wiederum vorzugsweise von etwa 1 : 1 einzuhalten. Relative Mengen außerhalb dieser gewünschten Bereiche ergeben nicht die einmalige Kombination vorzüglicher Eigenschaften, die gemäß der Erfindung erhalten wird. Wenn beispielsweise der epoxidierte Novolak in Mengen größer 4 : 1 verwendet wird, findet ein Gelieren der Zusammensetzung statt, welches für die einfache Möglichkeit des Auftrags schädlich ist und ebenso für die nachfolgende Entwicklung des gewünschten Musters. Darüber hinaus ergab die Verwendung von anderen Epoxiden als den zuvor angegebenen schlechtere Zusammensetzungen. Beispielsweise ergab ein Novolakharz [EPI-REZ Su 8] der Celanese Chemical Co., welches ein Octaglycidyläther des 2.2-Bis(4-hydroxyphenyl)-propan-formaldehyd-novolaks mit 8 Epoxidgruppen je Molekül ist und anstelle des epoxidierten Novolakharzes mit Acrylsäure umgesetzt wurde, keine guten filmbildenden Eigenschaften, obgleich die Bild und Muster erzeugenden Eigenschaften sehr gut waren.

Die relativen Mengen der Kombination der Epoxide liegen in der Zusammensetzung im allgemeinen zwischen 20 und 75%.

Die Bedingungen für die Vorreaktion sind bekannt und brauchen im Detail nicht näher beschrieben zu werden. Es sind beispielsweise Temperaturen von Zimmertemperatur bis etwa 75° C geeignet. Geeignete Zeiten für die Vorreaktion liegen bei 30 Min. und darüber.

Wenn ein relativ niedermolekulares Epoxidpolymer der Formel (I) verwendet und auf einen Träger laminiert wird, kann es erwünscht sein, eine geringe Menge eines relativ hochmolekularen Polymeren des gleichen Typs (bis zu etwa 10% des Gesamtgehaltes an dieser Epoxidkomponente) zuzugeben, um

...ie erhöhte Glätte des Filmes zu erhalten.

Die mehrfach äthylenisch ungesättigten Verbindungen, die in den erfindungsgemäßen Überzugsmassen verwendet werden, müssen bei Einwirkung von ultraviolettem Licht reagieren und sollten endständige Äthylengruppen enthalten. Solche Verbindungen schließen ungesättigte Ester von Polyolen ein und insbesondere Ester wie Äthylenglykoldiacrylat; Diäthylenglykol-diacrylat; Glycerindiacrylat; Glycerintriacrylat; Äthylenglykoldimethacrylat; 1,3-Propylenglykoldimethacrylat; 1,2,4-Butantriol-trimethacrylat; 1,4-Dihydroxybenzol-dimethacrylat; Pentaerythrit-tetramethacrylat; 1,3-Propandioldiacrylat; 1,6-Hexandiol-diacrylat; die Bis-acrylate und Methacrylate von Polyäthylenglykolen mit Molekulargewichten von 200 bis 500; Trimethylolpropan-triacrylat; Pentaerythrittriacrylat; ungesättigte Amide wie insbesondere von $\alpha,\Omega$-Diaminen und von mit Sauerstoff unterbrochenen $\Omega$-Diaminen wie Methylenbisacryl- und Bismethacrylamid; Diäthylentriamin; Tris-methacrylamid; Bis-(methacrylamidopropoxy)-äthan; Bis-methacrylamidoäthylmethacrylat; N-[($\beta$-hydroxyäthyloxy)-äthyl]-acrylamid; Vinylester wie Divinylsuccinat, Divinyladipat, Divinylphthalat, Divinylbenzol-1,3-disulfonat und Divinylbutan-1,4-disulfonat und ungesättigte Aldehyde wie Sorbaldehyd.

Die bevorzugten mehrfach äthylenisch ungesättigten Verbindungen schließen Polyäthylenglykoldiacrylate und Trimethylolpropan-triacrylate ein. Die relativen Mengen der mehrfach äthylenisch ungesättigten Verbindung, die erfindungsgemäß verwendet werden, sind 0,5 bis 40% und vorzugsweise 1 bis 20%.

Die Überzugsmassen der vorliegenden Erfindung enthalten weiterhin einen Photoinitiator oder Sensibilisator. Viele dieser Materialien sind bekannt. Beispiele geeigneter Photoinitiatoren schließen Anthrachinon und substituierte Anthrachinone wie alkyl- oder halogensubstituierte Anthrachinone, beispielsweise 2-tert-Butylanthrachinon, 1-Chloranthrachinon, p-Chloranthrachinon, 2-Methylanthrachinon, 2-Äthylanthrachinon und Octamethylanthrachinon; andere substituierte und nichtsubstituierte mehrkernige Chinone einschließlich 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, 3-Chlor-2-methylanthrachinon, Retenchinon, 7,8,9,10-Tetrahydro-naphthacenchinon und 1,2,3,4-Tetrahydrobenzanthracen-7,12-dion ein. Andere geeignete Photosensibilisatoren schließen Sensibilisatoren vom Halogentyp wie Kohlenstofftetrachlorid, Bromoform und Hexabromäthan ein. Weiterhin sind geeignet: Benztriazol, Benzoin, Chloranil, Benzil, Diacetyl, 5-Nitro-salicylaldehyd, 2,4-Dinitrotoluol. Wenn es gewünscht wird, können auch Mischungen von Photoinitiatoren verwendet werden. Bevorzugte Photoinitiatoren gemäß der Erfindung sind die Anthrachinone, beispielsweise tert-Butylanthrachinon. Der Photoinitiator wird in Mengen angewendet, die ausreichend sind, um die Überzugsmasse für ultraviolettes Licht zu sensibilisieren. Diese liegen im allgemeinen zwischen 0,1 und 10% und vorzugsweise zwischen etwa 0,1 und 5%. In einem bevorzugten Ausführungsbeispiel werden etwa 0,1 bis 5% tert-Butylanthrachinon angewendet. Wenn es gewünscht wird, können die Überzugsmassen auch ein organisches, nichtreaktives Verdünnungsmittel zur Vereinfachung des Auftragens einschließen. Beispiele geeigneter Lösungsmittel schließen Äthylenglykolätheracetat, Methyldiglykol, Butyldiglykol, Methylenchlorid und Ketone wie Methyläthylketon ein. Wenn eines dieser Verdünnungsmittel verwendet wird, wird es in einer Menge verwendet, daß die Zusammensetzungen eine Viskosität zwischen etwa 1 und etwa $17 \times 10^{-4}$ $m^2/s$ aufweisen.

Die Überzugsmassen der vorliegenden Erfindung können hergestellt werden, indem man zuerst eine Lösung von zwei verschiedenen Epoxidpolymeren herstellt und dann die Monocarbonsäure zusammen mit einem Promotor wie einem primären, sekundären oder tertiären Amin, beispielsweise Benzyldimethylamin, Triäthylamin oder Triäthanolamin; oder einem Metallsalz wie Zinn(II)octoat oder Eisen(II)octoat, die die Reaktion der Carbonsäuregruppe der Säure mit den endständigen Epoxidgruppen des Epoxidpolymeren begünstigen, zufügt.

Nach dem Mischen der Säure mit dem Epoxidharz werden die anderen Bestandteile, die mehrfach äthylenisch ungesättigte Verbindung und die Photoinitiatoren zu der Zusammensetzung zugefügt. Zusätzlich werden, wenn Verdünnungsmittel zur Herabsetzung der Viskosität der Zusammensetzung erwünscht sind, diese in diesem Stadium zugegeben. Wenn ein relativ hochmolekulares Polymer der Formel (I) zusätzlich zu den zwei erforderlichen Epoxidpolymeren verwendet wird, kann dieses vor oder nach der Reaktion mit der Carbonsäure zugefügt werden.

Anschließend wird die Überzugsmasse auf die gewünschte Unterlage in der gewünschten Schichtdicke aufgetragen. Im allgemeinen sind nicht mehr als etwa 0,254 mm, vorzugsweise nicht mehr als etwa 0,127 mm ausreichend für die Herstellung gedruckter Schaltkreisplatten, wobei etwa 0,051 mm einen noch geeigneten Minimalwert darstellen. Der Photoresist kann auf eine Trägerfolie oder auf die gewünschte Schaltkreisplatte je nach dem gewünschten Verfahren aufgetragen werden.

Die Trägerfolien müssen von der Überzugsmasse entfernt werden können, ohne daß die Integrität des Films zerstört wird, und sie sollten flexibel genug sein, daß sie aufgewickelt werden können. Geeignete Trägerfolien sind z. B. solche aus Polyäthylen, Polypropylen, Polyester wie Polyäthylenterephthalat, Wachspapier und Papier, welches einen Trennüberzug, beispielsweise aus einem Silicon, enthält. Wenn der Überzug vor der Entfernung der Trägerfolie belichtet werden soll, muß die Trägerfolie aus einem relativ teuren transparenten Material wie Polyäthylenterephthalat bestehen. Andererseits muß die Folie, wenn sie vor dem Belichten entfernt wird, nicht transparent sein, und es

kann eine relativ billige Folie aus Polyäthylen oder Polypropylen verwendet werden.

Der Film wird dann mit ultravioletter Strahlung durch eine transparente Abbildung des gewünschten Musters belichtet. Durch die Belichtung mit ultraviolettem Licht wird die Polymerzusammensetzung vernetzt, wodurch sie unlöslich wird. Nach dem Belichten mit ultraviolettem Licht und nach dem Entfernen der Trägerfolie, falls eine solche verwendet wird, wird der Überzug entwickelt, indem die nicht mit ultraviolettem Licht belichteten Bereiche entfernt werden. Dies kann durch Tauchen oder Besprühen des Films mit einem geeigneten Lösungsmittel geschehen. Einige geeignete Lösungsmittel schließen Methyldiglykol, Butyldiglykol, Butylglykolacetat, Äthylenglykolätheracetat und Diäthylenglykolmonoäthyläther ein. Das Lösungsmittel wird so gewählt, daß es die nichtgehärtete Polymerzusammensetzung löst, ohne in unerwünscht hohem Maße den gehärteten Überzug anzugreifen. Hierfür geeignete Lösungsmittel können von einem Fachmann leicht ermittelt werden.

Darüber hinaus kann der Film nachgehärtet werden, indem er erhöhten Temperaturen, beispielsweise von 100 bis 180° C eine halbe Stunde bis 10 Stunden lang ausgesetzt wird. Zusätzlich kann, um das Nachhärten zu erleichtern, ein weiteres Härtungsmittel aus einem geeigneten Lösungsmittel in den frisch gehärteten Film eindiffundieren. Dieses Härtungsmittel kann aus einer Vielzahl derselben, die Epoxidharzen bestimmte Eigenschaften verleihen, ausgewählt werden. Die Menge an Härtungsmittel, die in den Film eindiffundiert, wird durch die Konzentration und die Eintauchzeit in die Härtungslösung bestimmt. Zusätze, die normalerweise in der Epoxidharztechnologie verwendet werden, können auch bei den strahlungsempfindlichen Überzügen der vorliegenden Erfindung verwendet werden. Zusätze, die drastisch die Lichtabsorption des Überzugs herabsetzen oder den Photoresist nachteilig beeinflussen, müssen vermieden werden. Wenn Zusätze verwendet werden, sollten diese nach Erhalt des Vorreaktionsprodukts von Säure und Epoxidharz zugesetzt werden, um irgendwelche nachteilige Einflüsse auf die Reaktionsmechanismen zu vermeiden.

Substrate, auf die die strahlungsempfindlichen Überzüge normalerweise aufgetragen werden, können aus Metall, Kunststoff, Glas oder aus einem solchen Material bestehen, auf das Epoxidharze normalerweise aufgebracht werden. Der Spektralbereich der Belichtung, die Zeit und die Intensität für einen typischen strahlungsempfindlichen Überzug sind aus den nachfolgenden Bedingungen ersichtlich:

Überzug in einem Abstand von 76,2 cm von einer Quecksilberhochdrucklampe mit kurzem Lichtbogen, hergestellt von OSRAM GmbH, Deutschland, Modell HBO, 500 Watt; Dauer der Belichtung 2 bis 20 Min.

Da die Filme, die erfindungsgemäß hergestellt werden, visuell klar sind, hat die Filmdicke, wenn überhaupt, einen sehr kleinen Einfluß auf die benötigte Belichtungszeit.

## Beispiel 1

Zu einer 50%igen Lösung, die etwa 700 Gewichtsteile Äthylenglykolätheracetat und etwa 700 Gewichtsteile eines 2.2-bis(4-Hydroxyphenyl)propan-diglycidyläther-epoxidharzes (Epon Harz 1004 der Shell Chemical Co.) enthält und einer 50%igen Lösung von etwa 700 Gewichtsteilen Äthylenglykolätheracetat und einem festen Epoxidnovolakharz (Dow DX 7855 der Dow Chemical Co.) wurden etwa 250 Gewichtsteile Acrylsäure und etwa 14 Gewichtsteile Benzyldimethylamin als Promoter zugegeben. Man läßt die Mischung für etwa 20 Std. bei 65° C reagieren. Anschließend wird eine Vormischung von etwa 82 Gew.-% Polyäthylenglykoldiacrylat und etwa 41,25 Gewichtsteilen tert-Butylanthrachinon und etwa 244 Gewichtsteilen Äthylenglykolätheracetat zugegeben.

Die Zusammensetzung wird auf die eine Seite eines Polyäthylenterephthalatschichtträgers in einer Schichtdicke von 0,076 mm aufgetragen und mit einer Geschwindigkeit von etwa 3 m/Min. durch einen Ofen, der auf einer Temperatur von 135° C gehalten wird, geführt.

Die beschichtete Folie wird auf eine gedruckte Schaltplatte, beispielsweise auf ein mit Kupfer laminiertes Substrat unter gleichzeitigem Erhitzen auf 50 bis 120° C aufgetragen. Die Polyäthylenterephthalatfolie wird von dem Überzug unmittelbar vor der Belichtung abgeschält unter Zurücklassung eines intakten Films auf der Schaltplatte. Der Überzug wird durch einen Stufenkeil mit einer 500-Watt-Lampe, die zuvor beschrieben wurde, aus einer Entfernung von 76,2 cm belichtet. Belichtungszeiten von etwa 3 Min. sind mehr als ausreichend zur Herstellung eines annehmbaren Bildes nach der Entwicklung. Die Zusammensetzung wird durch Besprühen mit Butyldiglykol entwickelt. Nach dem Entwickeln wird die Zusammensetzung etwa 2 Stunden lang bei etwa 160° C nachgehärtet.

Mit der zuvor beschriebenen Überzugsmasse wurden ausgezeichnete Bilder mit scharfen Kanten und hervorragender Auflösung erhalten. Die Ergebnisse waren reproduzierbar bei Anwendung verschiedener Ansätze der oben beschriebenen Epoxidpolymeren. Weiterhin ist die gehärtete Zusammensetzung widerstandsfähig gegenüber den üblichen Lötwellenprozessen unter Verwendung eines niedrigschmelzenden Lots, beispielsweise eines Zinn-Blei-eutektischen Gemisches bei 260° C.

Beispiel 2

Zu einer 50%igen Lösung mit einem Gehalt an 700 Gewichtsteilen Äthylenglykolätheracetat und etwa 700 Gewichtsteilen an 2.2-bis(4-Hydroxyphenyl)propan-epoxidharz (Eponharz 1004) und einer 50%igen Lösung mit einem Gehalt an 700 Gewichtsteilen Äthylenglykolätheracetat und einem festen Epoxidnovolakharz (Dow CX 7855) wurden 250 Gewichtsteile Acrylsäure und etwa 14 Gewichtsteile Benzyldimethylamin als Promotor zugegeben. Man läßt die Mischung etwa 20 Std. lang bei 65°C reagieren. Anschließend wird eine Vormischung von etwa 82 Gewichtsteilen Polyäthylenglykoldiacrylat, etwa 41,25 Gewichtsteilen tert-Butylanthrachinon und etwa 32,58 Gewichtsteilen eines Silicons der Dow Chemical Co., welches ein alkylsubstituiertes cyclisches Silsequioxan gemischt mit Toluol ist, zugegeben.

Die Zusammensetzung wird auf eine gedruckte Schaltplatte, beispielsweise auf ein mit Kupfer laminiertes Substrat aufgesprüht und etwa 105 Min. lang auf 60°C erhitzt, wodurch ein Film mit einer Stärke von etwa 0,076 mm erhalten wird. Der Überzug wird durch einen Stufenkeil aus einer Entfernung von 76,2 cm mit einer 500-Watt-Lampe der zuvor beschriebenen Art belichtet. Belichtungszeiten von etwa 3 Min. sind mehr als ausreichend zur Herstellung eines brauchbaren Bildes nach der Entwicklung. Der Überzug wird entwickelt durch Aufsprühen von Butylglykolacetat. Die Zusammensetzung wird etwa 2 Std. lang bei 160°C nachgehärtet. Die Ergebnisse sind ähnlich wie in Beispiel 1.

Beispiel 3

Beispiel 1 wird wiederholt mit der Ausnahme, daß etwa 16,5 Gewichtsteile Kohlenstofftetrabromid verwendet werden. Die erhaltenen Ergebnisse sind ähnlich wie in Beispiel 1.

Beispiel 4

Beispiel 1 wird wiederholt unter Anwendung einer Zusammensetzung, welche aus etwa 26 Gew.-% Epoxidnovolakharz XD 7855 der Dow Chemical Co.; etwa 9,3 Gew.-% Acrylsäure; etwa 0,5 Gew.-% Benzyldimethylamin; etwa 30 Gew.-% Äthylenglykolätheracetat; etwa 0,5 Gew.-% Benztriazol und etwa 1,3 Gew.-% tert-Butylanthrachinon erhalten wurde. Die Ergebnisse sind ähnlich wie im Beispiel 1.

Beispiel 5

Beispiel 1 wird wiederholt mit der Ausnahme, daß 16,5 Gewichtsteile Benztriazol verwendet werden. Die erhaltenen Ergebnisse sind ähnlich wie in Beispiel 1.

Die zuvor angegebenen Überzugsmassen weisen eine einmalige Kombination von Eigenschaften auf, welche ausgezeichnete bilderzeugende Eigenschaften (d. h. hohe Auflösung und die Fähigkeit, einem Muster genau zu folgen) in Verbindung mit ausgezeichneten filmbildenden Eigenschaften wie gute Adhäsion, Flexibilität und gute Eigenschaften zur Überzugsbildung wie anfängliches Fließen beim Erhitzen umfassen. Die zuvor angegebenen Eigenschaften sind wahrscheinlich zurückzuführen auf die spezielle Kombination und die relativen Mengen der Epoxidharz-Säureaddukte in Kombination mit den anderen Bestandteilen. Obgleich Mischungen von Epoxidharzen per se in Überzugszusammensetzungen bereits verwendet wurden, wie aus den US-Patentschriften 3 930 856, 3 936 557, 3 752 669 und 3 826 650 bekannt ist, ist aus diesen Patentschriften die spezielle Mischung von Epoxidharz-Acrylsäureaddukten, die nach der vorliegenden Erfindung zwingend erforderlich ist, nicht bekannt. Auch ist diesen Patentschriften keinerlei Hinweis auf Mischungen zu entnehmen, welche die einmalige Kombination von Eigenschaften, die durch die vorliegende Erfindung erreicht werden, aufweisen.

**Patentansprüche**

1. Strahlungsempfindliche Überzugsmasse, die aus a) einem Epoxidharz, b) einem epoxidierten Novolak, c) einer mehrfach äthylenisch ungesättigten Verbindung, d) einem Photoinitiator und ggf. e) einem nichtreaktiven Verdünnungsmittel besteht, dadurch gekennzeichnet, daß sie als

a) ein filmbildendes Reaktionsprodukt aus einem Epoxid der allgemeinen Formel (I)

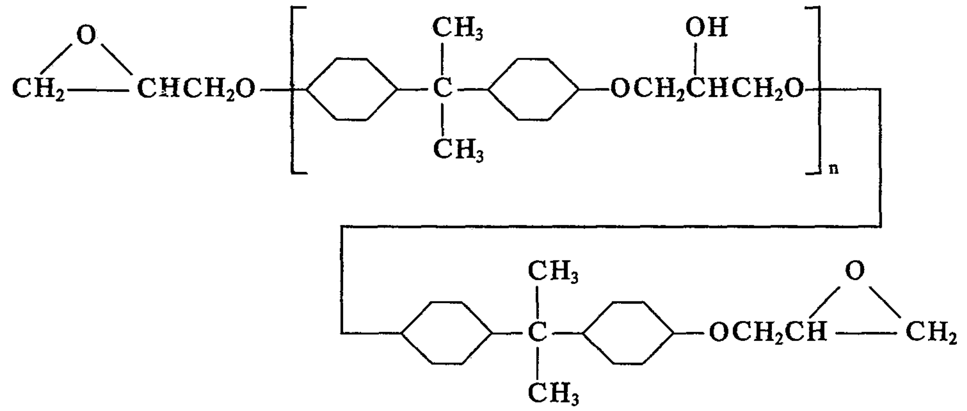

(I)

in der n 0,2 bis 100 ist und einer monoäthylenisch ungesättigten Carbonsäure in einer zur stöchiometrischen Umsetzung von 25 bis 100% der Epoxidfunktionalitäten des Epoxidharzes ausreichenden Menge, als

b) ein filmbildendes Reaktionsprodukt aus einem epoxidierten Novolak der allgemeinen Formel (II)

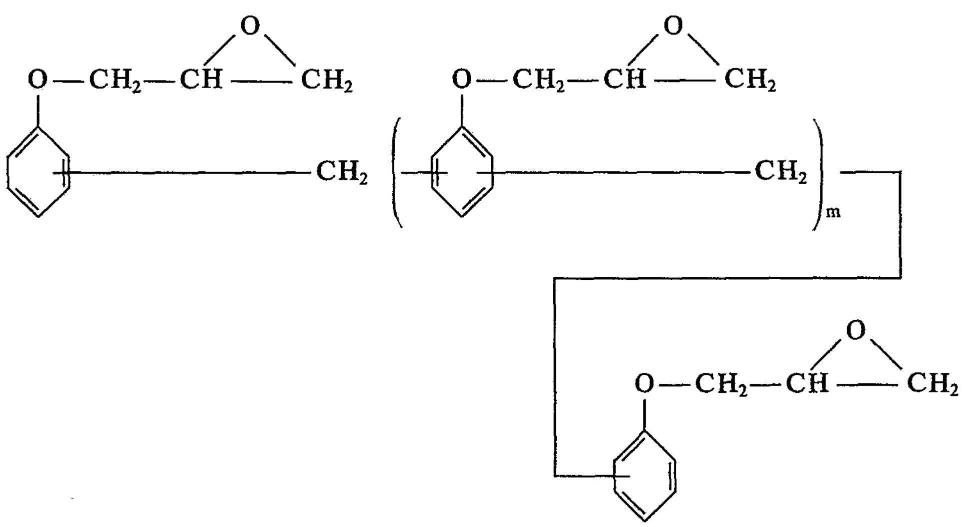

(II)

in der m 1,5 bis 3,5 ist, und einer monoäthylenisch ungesättigten Carbonsäure in einer zur stöchiometrischen Umsetzung von 25 bis 100% der Epoxidfunktionalitäten des Novolakharzes ausreichenden Menge,
in einem Verhältnis von a zu b zwischen 1 zu 4 und 4 zu 1, und

c) die mehrfach äthylenisch ungesättigte Verbindung in einer Menge von 0,5 bis 40 Gew.-%, bezogen auf die Gesamtzusammensetzung,

enthält.

2. Überzugsmasse nach Anspruch 1, dadurch gekennzeichnet, daß die monoäthylenisch ungesättigte Carbonsäure Acrylsäure, Methycrylsäure, Crotonsäure oder eine Mischung derselben ist.

3. Überzugsmasse nach Anspruch 1, dadurch gekennzeichnet, daß die mehrfach äthylenisch ungesättigte Verbindung (c) Polyäthylenglykoldiacrylat oder Trimethylolpropantriacrylat ist.

4. Überzugsmasse nach Anspruch 1, dadurch gekennzeichnet, daß das nichtreaktive Verdünnungsmittel Äthylenglykolätheracetat, Methyldiglykol, Butyldiglykol, Methylenchlorid oder Methyläthylketon ist und in einer Menge angewendet wird, daß Zusammensetzungen mit einer Viskosität zwischen 1 und $17 \times 10^{-4}$ $m^2/s$ erhalten werden.

5. Überzugsmasse nach Anspruch 1, dadurch gekennzeichnet, daß das Verhältnis der Bestandteile von a zu b 1 zu 1 ist.

6. Überzugsmasse nach den Ansprüchen 1 und 2, dadurch gekennzeichnet, daß das Verhältnis der monoäthylenisch ungesättigten Carbonsäure zu jedem der Epoxide so gewählt ist, daß eine stöchiometrische Umsetzung mit 25 bis 75% der Epoxidfunktionalität dieser Epoxide stattfindet.

7. Überzugsmasse nach Anspruch 1, dadurch gekennzeichnet, daß der Anteil der Epoxide an der Gesamtzusammensetzung 20 bis 75 Gew.-% beträgt.

8. Überzugsmasse nach Anspruch 1, dadurch gekennzeichnet, daß die Überzugsmasse bis zu 10 Gew.-%, bezogen auf den Gesamtgehalt an Epoxid der Formel (I), eines Epoxids der Formel (I) mit n von 10 bis 100 enthält.

9. Überzugsmasse nach den Ansprüchen 1 und 3, dadurch gekennzeichnet, daß der Anteil der mehrfach äthylenisch ungesättigten Verbindung (c) an der Gesamtzusammensetzung 1 bis 20 Gew.-% beträgt.

10. Verfahren zur Herstellung eines negativen Photoresistbildes, dadurch gekennzeichnet, daß ein Film aus der Überzugsmasse gemäß den Ansprüchen 1 bis 9, der auf einem Träger angeordnet ist, mit der Filmseite nach unten auf eine Schaltplatte auflaminiert wird, der Träger entfernt und der Film solange bildmäßig belichtet wird, bis er in den belichteten Bereichen gehärtet ist und daß die nichtbelichteten Bereiche des Films durch Entwickeln entfernt werden.

11. Verfahren nach Anspruch 10, dadurch gekennzeichnet, daß der Film nach dem Entfernen der nichtbelichteten Bereiche durch 0,5 bis 10 Stunden dauerndes Erhitzen auf 100 bis 180° C gehärtet wird.

**Claims**

1. Radiation-sensitive coating composition which consists of a) an epoxy resin, b) an epoxidized novolac, c) a polyethylenically unsaturated compound, d) a photo-initiator, and if necessary e) a non-reactive diluant, characterized in that it contains as

a) a film-forming reaction product of an epoxide of the general formula (I)

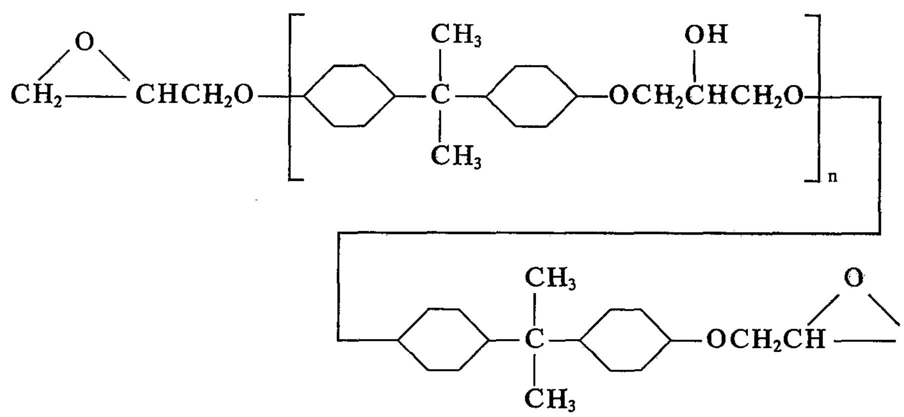

(I)

where n is 0,2 to 100, and of a monoethylenically unsaturated carboxylic acid in a quantity sufficient for the stoichiometric reaction of 25 to 100% of the epoxide functionalities of the epoxy resin, as

b) a film-forming reaction product of an epoxidized novolac of the general formula (II)

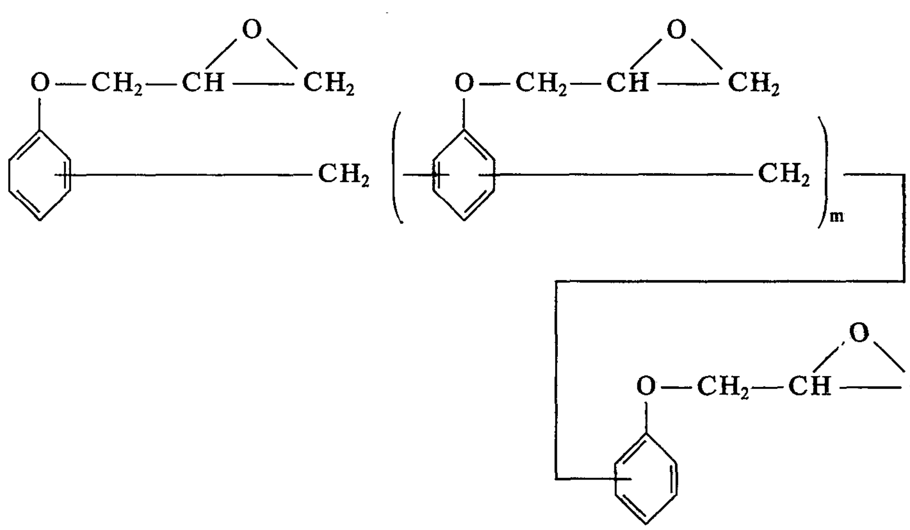

(II)

where m is 1,5 to 3,5, and of a monoethylenically unsaturated carboxylic acid in a quantity sufficient for the stoichiometric reaction of 25 to 100% of the epoxide functionalities of the novolac resin,
in a ratio of a to b between 1 to 4 and 4 to 1, and as

c) the polyethylenically unsaturated compound in a quantity of 0,5 to 40% by weight, referring to the overall composition.

2. Coating composition as claimed in claim 1, characterized in that the monoethylenically unsaturated carboxylic acid is acrylic acid, methacrylic acid, crotonic acid, or a mixture thereof.

3. Coating composition as claimed in claim 1, characterized in that the polyethylenically unsaturated compound (c) is polyethylene glycol diacrylate or trimethylol propane triacrylate.

4. Coating composition as claimed in claim 1, characterized in that the non-reactive diluant is ethylene glycol ether acetate, methyldiglycol, butyldiglycol, methylene chloride or methyl ethyl ketone, and that it is used in such a quantity that compositions with a viscosity between 1 and $17 \times 10^{-4}$ $m^2/s$ are obtained.

5. Coating composition as claimed in claim 1, characterized in that the ratio of the components of a to b is 1 to 1.

6. Coating composition as claimed in claims 1 and 2, characterized in that the ratio of the monoethylenically unsaturated carboxylic acid to each of the epoxides is selected in such a manner that a stoichiometric reaction with 25 to 75% of the epoxide functionality of these epoxides takes place.

7. Coating composition as claimed in claim 1, characterized in that the percentage of the epoxides in the overall composition amounts to 20 to 75% by weight.

8. Coating composition as claimed in claim 1, characterized in that the coating composition contains up to 10% by weight referring to the overall contents of epoxide of the formula (I), an epoxide of the formula (I) with n from 10 to 100.

9. Coating composition as claimed in claims 1 and 3, characterized in that the percentage of the polyethylenically unsaturated compound (c) in the overall composition amounts to 1 to 20% by weight.

10. Method of making a negative photoresist image, characterized in that a film of the coating composition in accordance with claims 1 to 9 which is arranged on a carrier is laminated with the film side facing downward onto a circuit board, that the carrier is removed, and that the film is subjected to image-wise exposure until it is cured in the exposed areas, and that the non-exposed film areas are removed through development.

11. Method as claimed in claim 10, characterized in that after the removal of the non-exposed areas the film is cured during 0,5 to 10 hours by being heated from 100 to 180° C.

**Revendications**

1. Composition d'un revêtement photosensible constitué a) d'une résine époxyde, b) d'une novolaque époxyde, c) d'un composé polyéthylèniquement non saturé, d) d'un photo-initiateur, et le cas échéant e) d'un diluant non réactif, caractérisée en ce qu'il comporte:

a) un produit de réaction de formation de film entre, d'une part, un époxyde de formule générale (I)

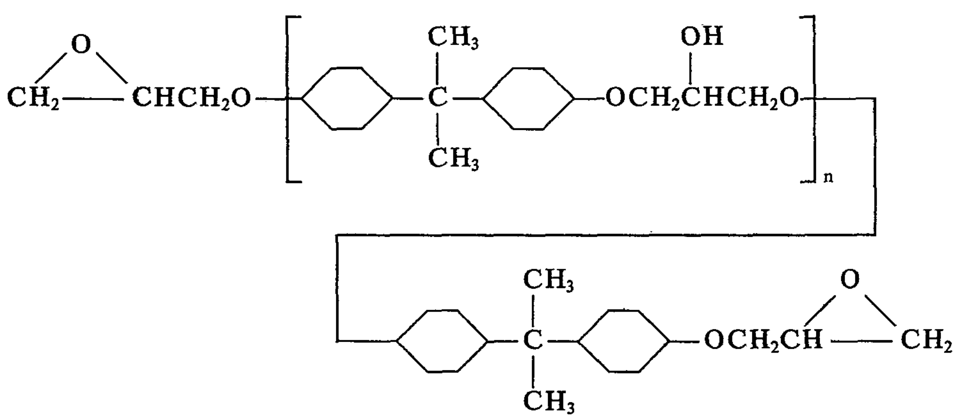

(I)

où n varie entre 0,2 à 100, et, d'autre part, un acide carboxylique monoéthyléniquement non saturé, en quantité suffisante pour réagir stoéchiométriquement avec 25 à 100% des propriétés époxydes de la résine époxyde,

b) un produit de réaction de formation de film entre, d'une part, une novolaque époxyde de formule générale (II)

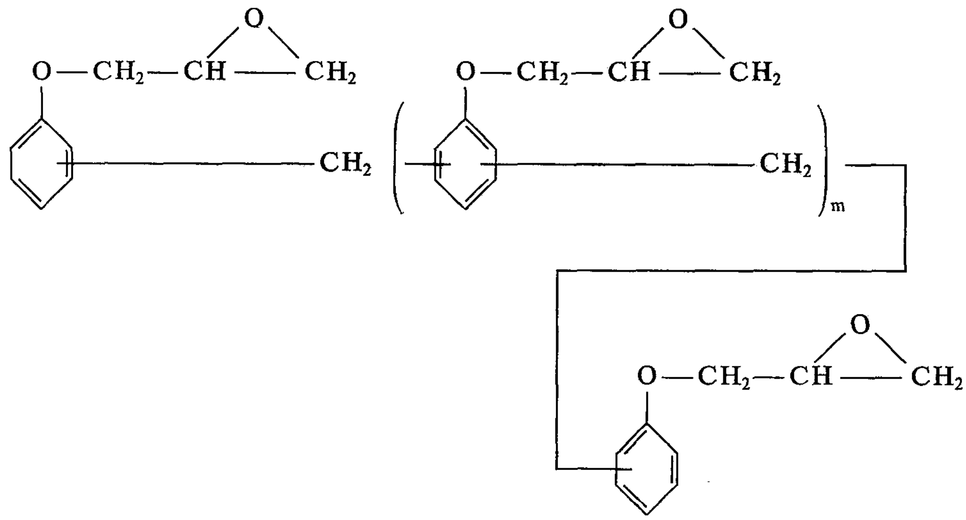

(II)

où n varie entre 1,5 à 3,5, et, d'autre part, un acide carboxylique monoéthyléniquement non saturé en quantité suffisante pour réagir stoéchiométriquement avec 25 à 100% des propriétés époxydes de la résine novolaque,

le rapport a à b variant de 1 à 4 et de 4 à 1, et en ce qu'il comporte

c) un composé polyéthyléniquement non saturé en quantité variant généralement entre 0,5 et 40% en poids par rapport à la totalité de la composition.

2. Composition du revêtement selon la revendication 1 caractérisée en ce que l'acide carboxylique monoéthyléniquement non saturé est un acide acrylique, un acide méthacrylique, un acide crotonique ou bien un mélange de ces composés.

3. Composition du revêtement selon la revendication 1, caractérisée en ce que le composé polyéthyléniquement non saturé c) est soit un polyéthylène glycol diacrylique soit un triméthylène propane triacrylique.

4. Composition du revêtement selon la revendication 1, caractérisée en ce que le diluant non réactif est soit un acétate d'éther éthylène glycol, soit un méthyldiglycol, soit un butyldiglycol soit un chlorure de méthylène, soit un méthyléthylcétone, ce diluant étant utilisé dans pour une quantité permettant d'obtenir des compositions ayant une viscosité variant entre 1 et $17 \times 10^{-4}$ $m^2/s$.

5. Composition du revêtement selon la revendication 1, caractérisée en ce que le rapport des constituants a à b est de 1 à 1.

6. Composition du revêtement selon les revendications 1 et 2 caractérisée en ce le rapport de l'acide carboxylique monoéthyléniquement non saturé et de chacun des époxydes est choisi de telle sorte qu'il permette une réaction stoéchiométrique avec 25% à 75% des propriétés époxydes dudit époxyde.

7. Composition du revêtement selon la revendication 1, caractérisée en ce que ledit époxyde représente 20% à 75% en poids de la totalité de la composition.

8. Composition du revêtement selon la revendication 1, caractérisée en ce que ladite composition du revêtement est composée d'un époxyde selon la formule (I) où n varie de 10 à 100, dans une proportion pondérale maximale de 10% pour la proportion totale d'époxyde dans la composition.

9. Composition du revêtement selon les revendications 1 et 3, caractérisée en ce que le composé monoéthyléniquement non saturé c) représente 1 à 20% en poids de la totalité de la composition.

10. Procédé de fabrication d'une image photorésistante négative, caractérisé en ce qu'une pellicule d'une composition de revêtement conforme aux revendications 1 à 9, et qui est monté sur un support, est déposée par laminage, la pellicule étant orientée vers le bas et faisant faice à une plaquette de circuits imprimés, en ce que le support est retiré, en ce que ladite pellicule est exposée pour former une configuration jusqu'à ce que les régions exposées durcissent, et en ce que les régions non exposées de ladite pellicule sont enlevées au cours du développement.

11. Procédé selon la revendication 10, caractérisé en ce que, une fois les régions non exposées enlevées, ladite pellicule est durcie à une température de cuisson allant de 100 à 180°C pendant une durée allant d'une demi-heure à 10 heures.